# FASCICULE DE BREVET EUROPEEN

(11) **EP 4 265 072 B1**
(45) Date de publication et mention de la délivrance du brevet: **04.12.2024**
(21) Numéro de dépôt: 21851684.7
(22) Date de dépôt: 16.12.2021
(51) Int. Cl.: H05H 1/46, H01J 37/34, H01J 37/32, C23C 14/00, C23C 14/32

(54) **DISPOSITIF POUR LE DÉPÔT DE FILMS MINCES ASSISTÉ PAR PLASMA MICRO-ONDE**
VORRICHTUNG ZUR ABSCHEIDUNG VON DÜNNSCHICHTEN MIT HILFE VON MIKROWELLENPLASMA
DEVICE FOR THE MICROWAVE PLASMA-ASSISTED DEPOSITION OF THIN FILMS

(30) Priorité: 18.12.2020 FR 2013733
(43) Date de publication de la demande: 25.10.2023
(73) Titulaire: Commissariat à l'Energie Atomique et aux Energies Alternatives, 75015 Paris (FR); Centre National de la Recherche Scientifique, 75794 Paris Cedex 16 (FR); Université Grenoble Alpes, 38401 Saint-Martin-d'Hères (FR); Institut Polytechnique de Grenoble, 38000 Grenoble (FR)
(72) Inventeur: LACOSTE, Ana, 38120 Saint-Égrève (FR); BES, Alexandre, 38210 Vourey (FR); OZANNE, Fabien, 38054 Grenoble Cedex 09 (FR)
(74) Mandataire: Brevalex
(86) Numéro de dépôt international: PCT/FR2021/052362
(87) Numéro de publication internationale: WO 2022/129799

(56) Documents cités:
- WO-A1-2008/009558
- WO-A1-2010/049456
- WO-A1-2014/009410
- US-A- 5 230 784
- US-A1- 2015 259 802

## Description

### DOMAINE TECHNIQUE ET ÉTAT DE LA TECHNIQUE ANTÉRIEURE

La présente invention se rapporte à un dispositif pour le dépôt de films minces assisté par plasma micro-onde.

Le procédé de dépôt en film mince par plasma repose sur la création de vapeurs atomiques par évaporation des cibles qui vont être déposés sur un substrat en tant que tels ou sous forme de composés chimiques formés à la surface de dépôt lorsque le plasma contient des espèces chimiques réactives (atomes, radicaux,...).

Le document US5677012 décrit une installation de dépôt par évaporation assistée par plasma comportant une enceinte sur une paroi latérale de laquelle est monté un canon à plasma, et sur la fond de laquelle est disposée un creuset comprenant le matériau à évaporer appelé cible. Le plasma généré par le canon à plasma doit être guidé jusqu'à la surface libre de la cible pour provoquer son évaporation. Des aimants permanents et une bobine sont mis en oeuvre autour du creuset pour guider le plasma.

Ce dispositif est relativement complexe, le guidage impose un fonctionnement à très basse pression, entre 0,18 Pa et 0,61 Pa. En outre il impose un réglage très précis en ce qui concerne l'intensité des champs magnétiques et la distance entre le canon à plasma et la cible. Ce dispositif étant formé de deux sous-dispositifs ayant une orientation relative très particulière, il est relativement encombrant. Les problématiques en termes de place et de réglage sont accentuées lorsque l'on souhaite effectuer des dépôts sur de grandes surfaces, imposant l'utilisation de plusieurs de ces dispositifs dans une même enceinte. Le document US5230784 A décrit une source de plasma micro-onde comportant un applicateur micro-onde dont le guide d'onde est coaxial et est formé d'un passage central et d'un conducteur externe. La cible de pulvérisation est montée dans le passage central, i.e. à l'extrémité de l'applicateur qui débouche dans la chambre de dépôt sous vide, et est entourée d'un canal annulaire de propagation des micro-ondes. Un ensemble d'aimants permanents est monté sous la cible pour permettre l'effet magnétron. Les documents WO 2014/009410 A1, WO 2010/049456 A1 et WO 2008/009558 A1 décrivent chacun un dispositif de production d'un plasma par résonance cyclotron électronique comportant une enceinte sous vide et un applicateur micro-ondes coaxial.

### EXPOSÉ DE L'INVENTION

C'est par conséquent un but de la présente invention d'offrir un dispositif pour le dépôt par évaporation ou par pulvérisation assistée par plasma ne présentant pas les inconvénients énoncés ci-dessus, le dépôt pouvant être réalisé par évaporation ou pulvérisation.

Le but énoncé ci-dessus est atteint par un dispositif pour le dépôt par évaporation ou par pulvérisation assistée par plasma destiné à être monté à travers la paroi d'une enceinte, comportant un dispositif de production d'un plasma micro-onde par résonance cyclotron électronique et un support pour la cible à évaporer disposé au centre du dispositif de production du plasma.

Le dispositif ainsi formé offre une grande compacité par rapport aux dispositifs de dépôt de l'état de la technique. En outre, il ne requiert pas de réglage complexe entre la source de plasma et la cible. De plus le dispositif intégrant en un seul objet la source plasma et la cible, l'intégration de plusieurs de ces dispositifs dans une enceinte est simplifiée. Il peut fonctionner sur une gamme de pression relativement large, par exemple s'étendant sur plus de trois ordres de grandeur.

Dans un exemple de réalisation de dépôt par évaporation, le support de cible comporte des moyens de chauffage afin d'évaporer la cible. Dans un autre exemple la cible peut être évaporée partiellement ou complètement par les électrons énergétiques du plasma. Le dispositif selon l'invention n'exige pas de polariser négativement la cible de matériau à déposer. Il en résulte qu'il n'y a pas de chute de tension à la cathode qui génère habituellement des espèces lourdes fortement énergétiques susceptibles d'endommager le film recouvrant le substrat. En revanche, dans certains modes de réalisation le dispositif de dépôt par évaporation selon l'invention peut mettre en oeuvre la polarisation positive de la cible.

Selon un exemple de dispositif de dépôt par pulvérisation, la cible est polarisée négativement.

En d'autres termes, on réalise un dispositif pour le dépôt par évaporation ou pulvérisation comportant un générateur de plasma par résonance cyclotron électronique qui intègre en son sein le matériau à évaporer ou à pulvériser. Le plasma renforce, voire assure en totalité, l'évaporation ou la pulvérisation de la cible. Pour cela, la structure magnétique est disposée par rapport à la cible de sorte que les lignes de champ croisent la surface de la cible.

Le dispositif pour le dépôt présente alors une grande compacité et le matériau à évaporer est situé au plus près du générateur de plasma, les électrons énergétiques du plasma participant à l'échauffement et à l'évaporation du matériau.

La présente demande a alors pour objet un dispositif pour le dépôt de film mince assisté par plasma, tel que défini par la revendication 1, comportant un dispositif de production d'un plasma micro-onde par résonance cyclotron électronique et un support d'un matériau cible destiné à former le film mince, ledit dispositif de production d'un plasma micro-onde comportant un corps d'axe longitudinal s'étendant entre une première face d'extrémité longitudinale et une deuxième face d'extrémité longitudinale et muni d'un passage central s'étendant entre la première face d'extrémité longitudinale et la deuxième face d'extrémité longitudinale, ledit support étant logé dans ledit passage central, ladite première face d'extrémité longitudinale étant destinée à être logée dans une enceinte d'une installation de dépôt, ledit corps comportant un passage annulaire de propagation d'un champ électrique micro-onde relié à une source de champ électrique micro-onde, ledit passage annulaire entourant le passage central et débouchant dans la première face d'extrémité longitudinale, au moins une cavité entourant le passage central et située à proximité de la première face d'extrémité longitudinale, une structure magnétique logée dans ladite cavité, ledit support comportant un panier configuré pour loger la cible et positionné de sorte que la face libre de la cible soit dans un plan de la première face d'extrémité longitudinale ou à proximité dudit plan et de sorte qu'au moins une partie des lignes de champ générée par la structure magnétique croise la cible, ledit dispositif pour le dépôt comportant également des moyens d'évaporation ou de pulvérisation du matériau cible.

Dans un exemple de réalisation, les moyens d'évaporation comportent des moyens de polarisation positive du matériau cible logés dans le support.

Les moyen d'évaporation peuvent comporter des moyens de chauffage du matériau cible logé dans le support.

Par exemple, les moyens de chauffage du matériau cible sont des moyens de chauffage à effet Joule ou par induction.

Dans un exemple de réalisation, les moyens de pulvérisation comportent des moyens de polarisation négative du matériau cible logé dans le support. Le dispositif pour le dépôt de film mince assisté par plasma peut comporter des moyens de refroidissement du matériau cible logés dans le support.

De préférence, le dispositif pour le dépôt de film mince assisté par plasma comporte des moyens de refroidissement du corps du dispositif de production d'un plasma micro-onde. De préférence, la structure magnétique comporte au moins un aimant permanent. Dans un autre exemple de réalisation, la structure magnétique comporte au moins un aimant permanent à aimantation radiale.

Dans un autre exemple de réalisation, la structure magnétique comporte au moins un aimant permanent à aimantation axiale dipolaire.

Dans un autre exemple de réalisation, la structure magnétique comporte au moins deux aimants permanents à aimantation axiale de polarité opposée.

Le dispositif pour le dépôt de film mince assisté par plasma peut comporter deux structures magnétiques concentriques et le passage annulaire de propagation peut déboucher dans la première face d'extrémité longitudinale entre les deux structures magnétiques.

Par exemple, le corps du dispositif de production d'un plasma micro-onde comporte un conducteur intérieur et un conducteur extérieur emboîtés l'un dans l'autre et définissant entre eux une partie du passage annulaire de propagation de l'onde. La présente demande a également pour objet une installation de dépôt de film mince assisté par plasma sur un substrat, telle que définie par la revendication 14, comportant une enceinte étanche, un porte-substrat et au moins un dispositif pour le dépôt de film mince assisté par plasma selon l'invention monté de manière étanche à travers une paroi de l'enceinte, de sorte que la première face d'extrémité longitudinale du corps soit à l'intérieur de l'enceinte.

De préférence, la paroi de l'enceinte est contenue dans un plan et le dispositif pour le dépôt de film mince assisté par plasma est monté dans la paroi de sorte que les intersections des lignes de champ magnétique et de ladite paroi sont minimisées.

La pression de gaz plasmagène dans l'enceinte est de préférence comprise entre 0,065 Pa et 133 Pa.

Selon une caractéristique additionnelle, l'installation de dépôt comporte des moyens de polarisation et/ou de chauffage du substrat.

### BRÈVE DESCRIPTION DES DESSINS

La présente invention sera mieux comprise sur la base de la description qui va suivre et des dessins en annexe sur lesquels:
[Fig. 1] est une représentation schématique d'un exemple d'une installation de dépôt assistée par plasma selon l'invention.
[Fig. 2] est une vue en coupe d'un exemple d'un dispositif pour le dépôt par évaporation assistée par plasma selon l'invention pouvant être mis en oeuvre dans l'installation de la figure 1, dans lequel la cible est chauffée par des moyens de chauffage extérieur.
[Fig. 3] est une vue en coupe du dispositif de génération de plasma du dispositif de la figure 2 représenté seul.
[Fig. 4] est une vue en coupe du dispositif d'évaporation du dispositif de la figure 2 représenté seul.
[Fig. 5A] est une représentation de l'enceinte de la figure 1 avec le dispositif D1 mettant en oeuvre une structure magnétique à aimantation axiale de polarité opposée.
[Fig. 5B] est une représentation de l'enceinte de la figure 1 avec le dispositif D1 mettant en oeuvre une structure magnétique à aimantation axiale de polarité opposée de dimension axiale plus grande que celle du dispositif de la figure 5A.
[Fig. 6A] est une représentation de l'enceinte de la figure 1 avec le dispositif D1 mettant en oeuvre une structure magnétique à aimantation radiale.
[Fig. 6B] est une représentation de l'enceinte de la figure 1 avec le dispositif D1 mettant en oeuvre une structure magnétique à aimantation radiale de dimension axiale plus petite que celle du dispositif de la figure 6A.
[Fig. 7] est une représentation de l'enceinte de la figure 1 avec le dispositif D1 mettant en oeuvre une structure magnétique à aimantation axiale dipolaire.
[Fig. 8] est une représentation schématique d'un dispositif pour le dépôt D5 selon un autre exemple de réalisation.
[Fig. 9] est une vue en coupe d'un autre exemple d'un dispositif pour le dépôt par évaporation assistée par plasma selon l'invention pouvant être mis en oeuvre dans l'installation de la figure 1, dans lequel la cible est polarisée.
[Fig. 10] est une vue en coupe d'un autre exemple d'un dispositif pour le dépôt par évaporation assistée par plasma selon l'invention pouvant être mis en oeuvre dans l'installation de la figure 1, dans lequel la cible est chauffée par des moyens de chauffage extérieur et polarisée.
[Fig. 11] est une vue en coupe d'un autre exemple d'un dispositif pour le dépôt par pulvérisation assistée par plasma selon l'invention pouvant être mis en oeuvre dans l'installation de la figure 1.

### EXPOSÉ DÉTAILLÉ DE MODES DE RÉALISATION PARTICULIERS

Dans la description qui va suivre, l'invention sera exposée en décrivant en détail une installation de dépôt par évaporation assistée par plasma et un dispositif pour le dépôt par évaporation assistée par plasma. Comme cela sera expliqué ci-dessous, l'invention concerne également un dispositif pour le dépôt par pulvérisation assistée par plasma et une installation de dépôt par pulvérisation assistée par plasma.

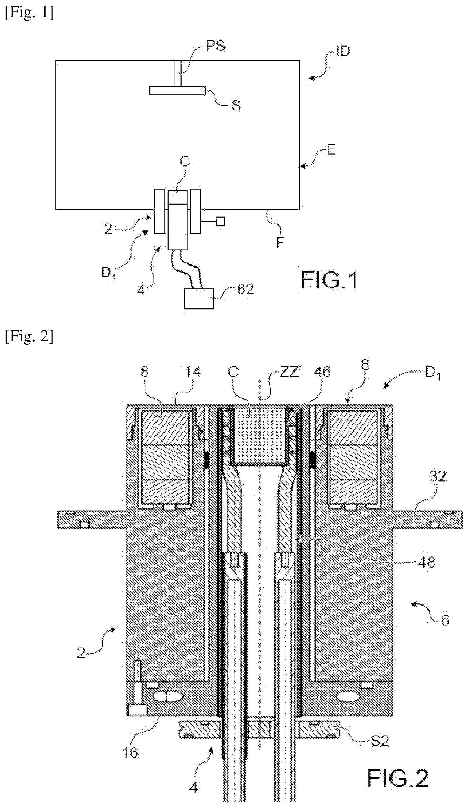

Sur la figure 1, on peut voir une représentation schématique d'une installation de dépôt ID par évaporation assistée par plasma intégrant un dispositif pour le dépôt par évaporation assistée par plasma selon l'invention.

L'installation comporte une enceinte E, un dispositif pour le dépôt par évaporation assistée par plasma D1, et un porte-substrat PS destiné à supporter le substrat S sur lequel on souhaite effectuer le dépôt. Le porte-substrat PS est en général disposé de sorte que le substrat soit en regard du dispositif pour le dépôt par évaporation assistée par plasma. Le dispositif D1 est monté à travers une paroi de l'enceinte, dans l'exemple représenté il s'agit du fond inférieur F de l'enceinte, mais cette disposition n'est pas limitative. L'enceinte est destinée à contenir un gaz plasmagène, par exemple à basse ou très basse pression, par exemple entre 0,065 Pa et 133 Pa (0,5 mTorr et 1000 mTorr).

Le dispositif pour le dépôt D1 comporte un dispositif de génération d'un plasma 2 et un dispositif 4 configuré pour assurer l'évaporation du matériau cible à déposer sur le substrat.

Le dispositif pour le dépôt présente une forme générale de révolution.

Le dispositif de génération d'un plasma 2 est un dispositif de génération d'un plasma micro-onde par résonance cyclotron électronique.

Le principe de fonctionnement de ce dispositif est d'appliquer un champ électrique haute fréquence, par exemple 2,45 GHz, appelé champ micro-onde à un gaz plasmagène, en présence d'un champ magnétique. Par phénomène de résonance cyclotron électronique ou RCE un plasma est généré dans les zones où la fréquence cyclotron est égale à la fréquence du champ micro-onde et est confiné par le champ magnétique.

Sur les figures 2 à 4, on peut voir en détail le dispositif 2. Celui-ci comporte un coupleur micro-onde 6 et une structure magnétique 8.

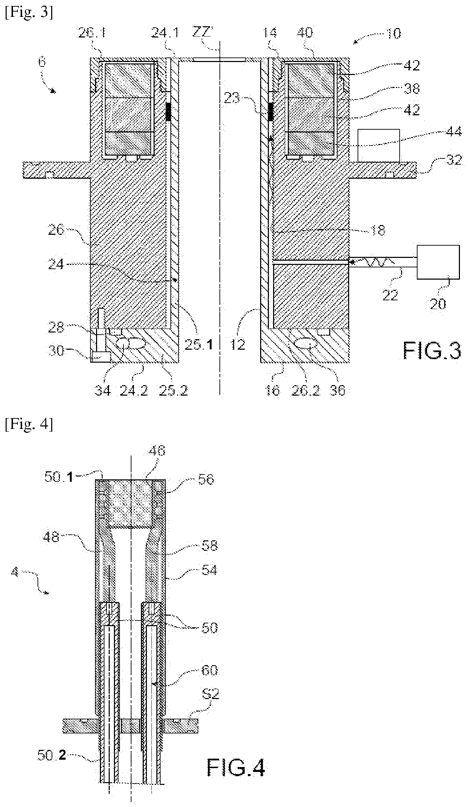

Sur la figure 3, on peut voir en détail le coupleur micro-onde 6 comportant un corps 10 d'axe longitudinal ZZ' muni d'un passage central 12 d'axe longitudinal débouchant aux deux extrémités du corps 10. Le corps 10 comporte une première face d'extrémité 14 destinée à être disposée dans l'enceinte et située près de la zone de résonance cyclotron électronique dite zone RCE, et une deuxième face d'extrémité 16 destinée à être disposée à l'extérieur de l'enceinte.

Le corps 10 comporte également un canal 18 de propagation du champ micro-onde de forme annulaire, entourant le passage central 12 et débouchant dans la première face d'extrémité 14. Le canal de propagation 18 est connecté à un générateur de puissance haute fréquence 20, qui délivre le champ micro-onde, via un connecteur d'alimentation en micro-ondes 22.

Le canal de propagation délimite le milieu de propagation du champ micro-onde. Le milieu de propagation peut comporter de l'air et/ou un matériau diélectrique de permittivité différente de 1. Dans l'exemple représenté, le milieu de propagation est constitué d'air et d'un tronçon annulaire 23 en matériau diélectrique, par exemple en alumine (Al₂O₃), en quartz ou en téflon.

Si le milieu de propagation comporte une fenêtre diélectrique, celle-ci n'a pas nécessairement vocation à assurer l'étanchéité au vide.

Le dispositif peut fonctionner avec ou sans adaptateur d'impédance en fonction de la conception géométrique du corps 10, de la fréquence HF utilisée, de la nature et de la pression du gaz plasmagène, de la puissance micro-onde. Lorsqu'un adaptateur d'impédance est mis en oeuvre, il est inséré entre le connecteur d'alimentation en micro-ondes 22, et le générateur de puissance haute fréquence 20.

Le champ micro-onde est guidé sur toute la longueur du canal de propagation depuis le connecteur d'injection de micro-ondes 22 jusqu'à la première face d'extrémité 14.

Dans l'exemple représenté, le corps 10 comporte un conducteur intérieur 24 et un conducteur extérieur, 26 emboîtés l'un dans l'autre et définissant entre eux une partie du canal de propagation.

Le conducteur intérieur 24 est désigné « âme centrale » et le conducteur extérieur 26 est désigné « blindage ». L'âme centrale 24 comporte un tube 25.1 muni à une extrémité 24.2 d'une embase 25.2 formant bride, et le blindage comporte un tube monté autour du tube 25.1 de l'âme centrale et dont une extrémité longitudinale 26.2 vient reposer sur la bride 25.2. Les autres extrémités 24.1 de l'âme centrale et 26.1 du blindage forment la première face d'extrémité 14 du coupleur.

Le canal de propagation 18 est délimité entre le diamètre extérieur de l'âme centrale 24 et le diamètre intérieur du blindage 26. Le contact entre la bride 25.2 et l'extrémité 26.2 du blindage 26 est étanche au vide. Pour cela un joint (non représenté) monté dans une gorge 28 formée dans l'extrémité du coupleur est prévu. L'âme centrale 24 et le blindage 26 sont solidarisés l'un à l'autre par exemple au moyen de vis 30 montées entre la bride 25.2 et l'extrémité du blindage. D'autres moyens de solidarisation sont envisageables. En général, le blindage et l'âme centrale sont réalisés dans le même métal très bon conducteur électrique et très bon conducteur thermique avec des pertes micro-onde d'insertion faibles. Le métal peut être choisi par exemple parmi l'argent, le cuivre, l'aluminium et l'acier inoxydable. En variante des métaux différents sont utilisés par exemple pour des raisons de réalisation de brasure, de soudure et/ou de tenue mécanique.

Le corps 10 comporte également des moyens de fixation à travers une paroi de l'enceinte. Dans cet exemple, le blindage 26 comporte sur sa face extérieure une bride 32 destinée à venir en appui contre une face interne du bord d'une ouverture formée dans le fond F de l'enceinte. Des moyens d'étanchéité sont également prévus entre la bride 32 et la paroi de l'enceinte. La bride 32 est positionnée sur le blindage 26 de sorte que la connexion micro-onde soit à l'extérieur de l'enceinte. La bride 32 est fixe à la paroi de l'enceinte par des moyens mécaniques de fixation, par exemple des griffes intérieures à l'enceinte. Dans une variante de réalisation, la face latérale extérieure du coupleur comporte un filetage coopérant avec un taraudage formé dans le bord de l'ouverture de la paroi de fond.

Des moyens de refroidissement du coupleur sont de préférence prévus. Dans cet exemple, un circuit fluidique est formé dans la bride 25.2 de l'âme centrale 24, dont les entrées 34 et sortie 36 sont représentées. Le caloporteur utilisé est par exemple de l'eau. De préférence, des circuits de circulation de caloporteur distincts sont mis en oeuvre pour refroidir l'âme centrale 24 et le blindage 26.

Le coupleur micro-onde 6 comporte également un logement pour la structure magnétique 8 située au plus près de la première face d'extrémité 14.

Dans l'exemple représenté sur la figure 3, le logement est formé par une cavité annulaire 38 située dans l'extrémité 26.1 du blindage et dimensionné pour recevoir la structure magnétique. La structure magnétique 8 comporte des moyens de génération d'un champ magnétique, de préférence il s'agit d'aimants permanents 42, ce qui est favorable à la compacité du dispositif. En variante, un ou plusieurs électroaimants sont mis en oeuvre, néanmoins ils requièrent une alimentation électrique qui rend le dispositif plus complexe et plus encombrant.

La cavité 38 est fermée de manière étanche par un capot 40 formant la première face d'extrémité 14. Un refroidissement des aimants est également prévu, par exemple le circuit de refroidissement du blindage traverse la cavité 38. L'assemblage du capot 40 sur le blindage est alors étanche au liquide.

La structure magnétique 8 comporte un ou plusieurs aimants annulaires 42. Des aimants présentant des aimantations de différentes orientations peuvent être utilisés comme cela sera détaillé ci-dessous. Il peut s'agir d'aimant à aimantation radiale ou d'aimant à aimantation axiale. La dimension des aimants dans la direction de l'axe ZZ' peut varier en fonction de l'application.

Des cales non magnétiques 44, par exemple en aluminium, peuvent être introduites dans la cavité 38 pour ajuster la position des aimants le long de l'axe. En effet, l'ajustement de la position axiale des aimants permet d'ajuster la position de la zone RCE et d'améliorer ainsi l'efficacité de production du plasma.

Dans le même objectif, une ou plusieurs cales peuvent être avantageusement disposées entre la bride 32 et la paroi de fond F pour ajuster la position du dispositif pour le dépôt par rapport au plan P2 de la paroi de fond F. La mise en oeuvre des cales permet d'éviter d'avoir à fabriquer plusieurs blindages 26 dont les bride 32 auraient des positions différentes le long de l'axe ZZ', ce qui offre une certaine flexibilité au niveau de l'ajustement de la surface 14 par rapport à la paroi de fond F de la chambre. L'orientation de l'aimantation et la dimension axiale du ou des aimants déterminent la forme des lignes de champ et la localisation et l'étendue de la zone RCE ou zone de résonance cyclotron électronique qui permettent de réguler le transport des espèces du gaz plasmagène et de vapeur de la cible vers la surface de dépôt. Sur les figures, la référence RCE désigne le contour de la surface iso-B (875 gauss pour une onde à 2,45 GHz) où les électrons absorbent de l'énergie du champ micro-onde par phénomène résonnant.

La zone RCE peut recouvrir partiellement, complètement ou pas du tout la surface de la cible C.

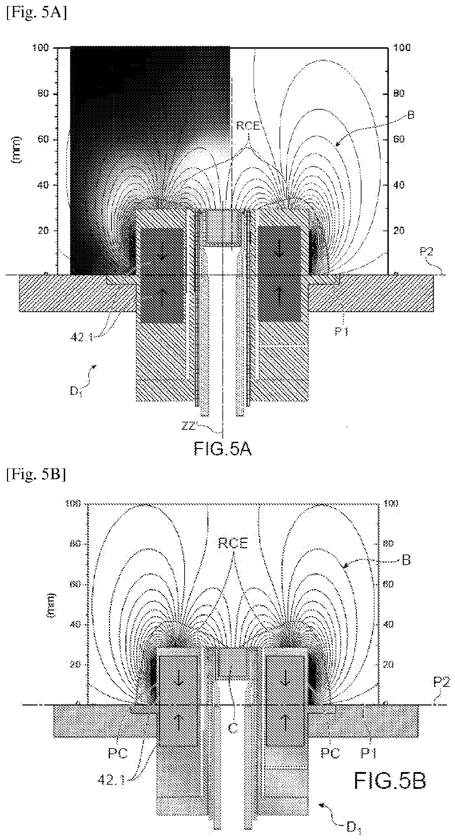

De manière préférée, les aimants sont positionnés par rapport à la paroi F de l'enceinte à travers laquelle le dispositif D1 est monté de préférence de telle sorte que les lignes de champ B convergent sur la face extérieure du blindage 26 et ne coupent pas ou le moins possible la paroi F de l'enceinte pour limiter les pertes sèches de particules du plasma. Pour cela les aimants sont de préférence positionnés de sorte que les lignes de champ B convergent sur la face extérieure du blindage au niveau de la surface intérieure de la chambre. Ces points de convergence sont désignés par PC sur les figures 5A à 7 montrant les lignes de champ B et les zones RCE pour différentes aimantations. La dimension axiale des éléments est repérée par les axes gradués en mm.

Sur les figures 5A et 5B, la structure magnétique comporte deux aimants permanents 42.1 à aimantation axiale montés tête-bêche et formant une structure à aimantation axiale de polarité opposée. Les flèches symbolisent l'orientation de l'aimantation. Sur la figure 5B, les aimants présentent une dimension le long de l'axe ZZ' plus grande que les aimants sur la figure 5A.

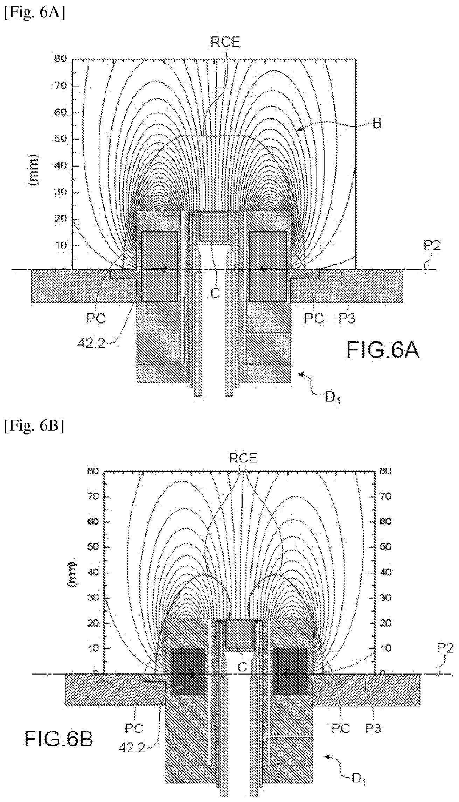

Sur les figures 6A et 6B, la structure magnétique comporte un aimant permanent à aimantation radiale 42.2. Les flèches symbolisent l'orientation de l'aimantation. Sur la figure 6B, les aimants présentent une dimension le long de l'axe ZZ' plus petite que les aimants sur la figure 6A.

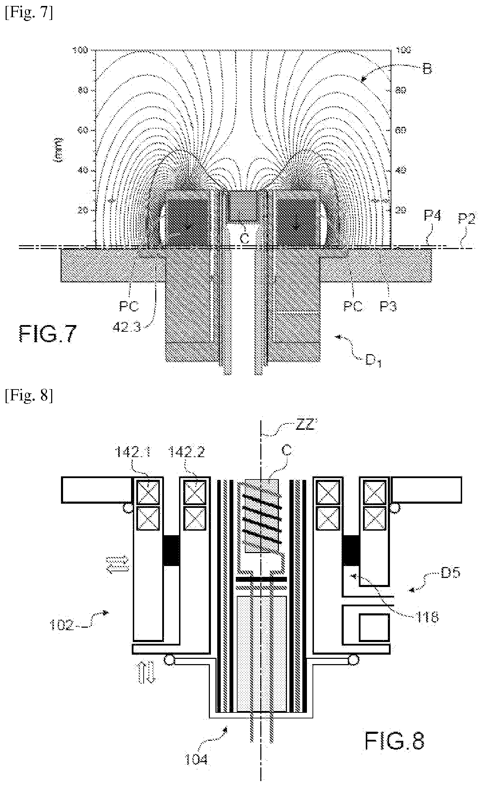

Sur la figure 7, la structure magnétique comporte un aimant permanent à aimantation axiale dipolaire 42.3. Les flèches symbolisent l'orientation de l'aimantation.

Un aimant à aimantation axiale dipolaire et un aimant à aimantation radiale d'une longueur souhaitée peuvent être obtenus par l'empilement de plusieurs aimants de longueurs plus petites. De plus, pour former un aimant en forme d'anneau, on assemble des secteurs d'aimants. Dans la suite de la description, on pourra donc parler d'un aimant ou des aimants de la structure magnétique.

Pour les structures à aimantation axiale à polarité opposée, les aimants sont disposés dans la cavité de sorte que, de préférence, le plan de contact P1 entre les deux aimants soit coplanaires avec le plan P2 du fond inférieur F de l'enceinte. Les lignes de champ B rebouclent dans ce plan P2, limitant l'intersection des lignes de champ avec le fond inférieur de l'enceinte comme cela est visible sur les figures 5A et 5B. L'ajustement de la position du plan P1 par rapport au plan P2 peut être obtenu au moyen de cales non magnétiques par exemple en aluminium, de différentes épaisseurs de dimensions transversales proches de celles des aimants pour pouvoir être logées dans la cavité. En outre, sur la figure 5A, la zone RCE de forme annulaire ne recouvre pas la cible, alors que sur la figure 5B elle couvre en partie la cible.

Pour les structures à aimantation radiale, l'aimant 42.2 est disposé dans la cavité de sorte que, de préférence, le plan médian P3 de l'aimant soit coplanaire avec le plan P2 du fond inférieur de l'enceinte. Les lignes de champ magnétique rebouclent dans ce plan P2, limitant l'intersection des lignes de champ avec le fond inférieur de l'enceinte comme cela est visible sur les figures 6A et 6B. Des cales en matériau non magnétique peuvent également être utilisées. Sur la figure 6A, la zone RCE recouvre entièrement l'extrémité du dispositif pour le dépôt dans l'enceinte formant une zone étendue de production de plasma. Sur la figure 6B la zone RCE de forme annulaire ne recouvre pas la cible.

Pour les structures à aimantation axiale dipolaire, l'aimant est disposé dans la cavité de sorte que, de préférence, le plan P4 d'une face de l'aimant normale à l'aimantation soit coplanaire avec le plan P2 du fond inférieur de l'enceinte. Une partie des lignes de champ magnétique B croise le fond de l'enceinte comme cela est visible sur la figure 7. Cela conduit à de pertes de particules sur la paroi du fond de la chambre plus importantes par rapport aux autres structures ci-avant indiquées. Cependant cette configuration est acceptable car la production du plasma est essentiellement repartie devant la partie centrale du dispositif et l'orientation des lignes du champ magnétique favorise le transport de particules vers le substrat.

Sur la figure 7, la zone RCE de forme annulaire ne recouvre pas la cible.

Une ou plusieurs cales 44 peuvent être disposées entre la bride 32 et le fond F de l'enceinte pour éloigner l'aimant du fond et permettre aux lignes de champ de reboucler en limitant l'intersection avec le fond.

Il est également envisageable d'éloigner la zone RCE de sorte qu'elle enveloppe tout ou partie de la surface de la cible, par exemple en utilisant un aimant plus long. Des cales 44 peuvent être utilisées pour repositionner les plans P2 et P4.

La structure magnétique garantit une surface RCE couvrant au moins une zone autour de l'injection des micro-ondes pour éviter le rayonnement inutile du champ électromagnétique. Comme cela a été décrit ci-dessus, la zone RCE peut également traverser entièrement les lignes de champ B et entourer ainsi complètement la structure (figure 6A), ce qui étend la zone susceptible de produire du plasma. Elle peut également croiser ou non la surface de la cible ce qui permet, en faisant la varier la zone de chevauchement de la surface RCE et la surface de la cible, d'augmenter ou de réduire le flux d'électrons chauds contribuant à l'évaporation de la cible.

Sur la figure 4, on peut voir représenté seul le dispositif 4 configuré pour assurer l'évaporation du matériau cible à déposer sur le substrat. Le dispositif 4 est configuré pour être logé dans le passage central 12 du coupleur micro-onde et à positionner la cible au plus près de la première face d'extrémité 14.

Le dispositif 4 comporte un panier 46 destiné à recevoir la cible C à évaporer et un support 48 supportant le panier 46 afin de la disposer au plus près de la première face d'extrémité. Dans cet exemple, le support comporte deux tubes 50 s'étendant sensiblement axialement le long de la direction dont une première extrémité 50.1 supporte le panier et une deuxième extrémité 50.2 traverse une platine de fixation S2 à la deuxième face d'extrémité 16 du coupleur.

Le montage des tubes 50 dans la platine de fixation S2 et le montage de la platine de fixation sur la deuxième face d'extrémité 16 du coupleur sont étanches au vide.

Le dispositif 4 comporte également un élément 54 formant bouclier entourant le panier et son support et assurant l'isolation électrique et thermique, permettant de limiter le transfert de chaleur de l'évaporateur vers âme centrale 24 du coupleur. Le bouclier 54 est formé par un manchon, dans lequel sont montés les tubes 50 et le panier 46.

Dans cet exemple, le dispositif 4 comporte des moyens de chauffage 56 de la cible portés par les premières extrémités 50.1 des tubes. Dans cet exemple les moyens de chauffage 56 sont du type à effet Joule et une ou des résistances électriques sous forme de conducteurs filaires sont logées dans la face intérieure du tube au droit de la paroi latérale du panier. Dans cet exemple, les tubes sont réalisés en deux parties, une première partie 58 pleine portant le panier et les moyens de chauffage et une deuxième partie 60 creuse montée dans la platine de fixation S2 et formant connecteur électrique destiné à être relié à un générateur de courant continu 62 (figure 1) pour l'alimentation électrique des moyens de chauffage. La deuxième partie 60 est creuse afin de permettre avantageusement son refroidissement.

En variante, le chauffage de la cible peut être obtenu par un chauffage par four. Les moyens de chauffage comportent alors une résistance sous forme de cylindre entourant le panier. Les tubes 60 sont également avantageusement refroidis dans cette variante.

En variante, les moyens de chauffage sont des moyens de chauffage à induction. Le fil est alimenté en courant variable dans le temps, qui crée un champ magnétique variable, qui induit un courant dans le matériau de la cible et donc son chauffage.

La cible est portée à la température nécessaire à son évaporation par les moyens de chauffage mis en oeuvre et/ou par la contribution des électrons énergétiques guidés vers la surface de la cible par les lignes magnétiques qui l'interceptent.

Le matériau du panier est adapté à la température de fusion de la cible pour éviter la pollution du dépôt.

L'extrémité ouverte du panier 46 peut être agencée dans l'alignement, en retrait ou encore en avance par rapport à la première face d'extrémité 14. Ce positionnement, choisi en fonction du type de chauffage et de la configuration magnétique utilisés, peut favoriser avantageusement le chauffage de la surface de la cible et l'ionisation des vapeurs par les électrons du plasma.

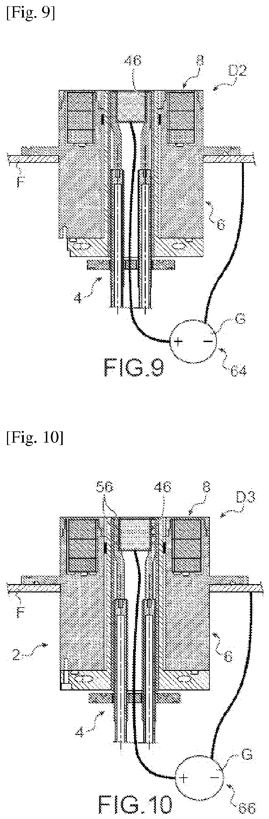

Dans un autre exemple de réalisation, le dispositif 4 ne comporte pas de moyens de chauffage et le chauffage de la cible en vue de son évaporation est obtenu uniquement par les électrons énergétiques du plasma. En effet, les électrons énergétiques ayant une vitesse parallèle aux lignes de champ magnétique interceptant le panier contribuent à l'évaporation. Ce flux peut donc contribuer au chauffage de la surface mais sans être suffisant pour atteindre la température nécessaire à l'évaporation. L'augmentation du flux d'électrons et l'augmentation de leur énergie sont obtenues par la polarisation positive de la cible pour obtenir un courant d'électrons (de l'ordre de quelques ampères) suffisant à l'évaporation de la surface de la cible. Sur la figure 9, on peut voir un exemple de dispositif D2 comportant des moyens de polarisation 64 comprenant un générateur de tension G dont une borne est reliée au panier 46 et une borne est reliée à l'enceinte.

Cet exemple présente l'avantage de lever la limite de la température imposée par le matériau du panier. En effet, lorsque des moyens de chauffage sont mis en oeuvre et que la température de fusion du matériau de la cible est élevée, le matériau du panier doit avoir une température de fusion suffisamment haute pour ne pas risquer le matériau de la cible, peu de matériau sont utilisables, et les quelques matériaux généralement utilisés pour le panier sont l'alumine, le carbure de silicium et le nitrure de silicium.

Dans un autre exemple de réalisation représenté, le chauffage de la cible est obtenu conjointement par les moyens de chauffage extérieurs et par le flux d'électrons augmenté par la polarisation positive de la cible. Sur la figure 10, on peut voir un exemple de dispositif D3 comportant des moyens de polarisation 66, un générateur de tension G dont une borne est reliée au panier 46 et une borne est reliée à l'enceinte et des moyens de chauffage 56 tels que décrits en relation avec le dispositif D1. Dans ce cas, la polarisation de la cible est réduite par rapport à celle de l'exemple de réalisation précédent et, de ce fait, le flux d'électrons extraits du plasma est plus faible. Ce mode de réalisation présente l'avantage de limiter l'appauvrissement du plasma en électrons et, en même temps, de réduire le chauffage extérieur requis. De ce fait, pour des matériaux avec des points d'évaporation élevés (proches du point de fusion du panier) le risque de contamination est fortement réduit.

Le dispositif 4 est positionné dans le dispositif 2, plus particulièrement la cible C est positionnée à l'intérieur de la structure magnétique de sorte que les lignes de champ magnétique B interceptent la surface libre de la cible C. Ainsi des électrons énergétiques du plasma frappent la cible C et participent à l'évaporation du matériau.

Un exemple de fonctionnement de l'installation de dépôt par évaporation assistée par plasma sans polarisation de la cible va maintenant être décrit.

Le substrat S sur lequel on veut effectuer le dépôt est placé dans l'enceinte E sur le porte-substrat PS sensiblement en regard du dispositif D1. La cible C de matériau à déposer est placée dans le panier 46. L'uniformité, la vitesse de dépôt et les propriétés des films déposés sont déterminées par les conditions opératoires telles que la pression et la composition du gaz plasmagène, la puissance micro-onde, la configuration du champ magnétique, le courant du moyen extérieur de chauffage, et la distance entre la surface libre de la cible C et le substrat S.

Par exemple le gaz plasmagène est choisi parmi Ar, O₂, H₂, ou des mélanges Ar/O₂, Ar/H₂, Ar/O₂/H₂, Ar/N₂/O₂, etc. Tout gaz réactif peut être utilisé comme additif à un gaz porteur, généralement de l'argon, selon la nature du dépôt à réaliser, par exemple un oxyde, un hydrure, un nitrure, un oxynitrure.

Un champ micro-onde est injecté dans le coupleur et la cible C est chauffée par les moyens de chauffage.

La zone RCE permet un transfert très efficace d'énergie du champ électrique micro-onde aux électrons qui s'enroulent autour des lignes de champ B assurant leur confinement, et à chaque passage dans la zone RCE, statistiquement ils gagnent de l'énergie. Ces électrons génèrent un plasma par collision avec les particules neutres du gaz plasmagène et les vapeurs issues de la cible. En outre, des lignes de champ B interceptant la surface libre de la cible, des électrons énergétiques du plasma viennent percuter la cible et participent à son évaporation. Sur la partie gauche de la figure 5A, les zones les plus claires sont les zones peuplées d'électrons énergétiques avec une concentration importante au niveau de la surface de la cible.

Les espèces lourdes, telles que les ions et les neutres, et les électrons thermalisés diffusent collectivement par le biais des collisions, et sont entraînés vers le substrat de dépôt, le matériau de la cible se dépose alors sur le substrat.

Le flux d'espèces du gaz plasmagène est contrôlé principalement par la puissance et la pression. De plus, le flux d'espèces du gaz plasmagène et de vapeurs peut être déterminé par le choix d'une configuration magnétique appropriée selon laquelle plus ou moins de lignes de champ interceptent la cible, selon laquelle une zone RCE est plus ou moins éloignée, et/ou plus ou moins étendue.

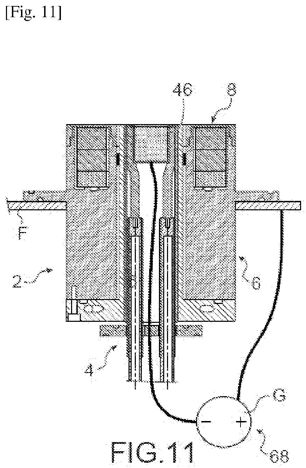

Selon un autre exemple de réalisation particulièrement avantageux représenté sur la figure 11, la cible n'est pas évaporée mais pulvérisée. La structure du dispositif D4 de dépôt par pulvérisation est similaire au dispositif de dépôt par évaporation, mais il ne comporte pas de moyens de chauffage de la cible, la pulvérisation de la cible étant obtenue en polarisant la cible négativement par une tension continue dans le cas d'un matériau de cible conducteur électrique ou par radiofréquence dans le cas d'un matériau de cible non conducteur électrique. Le dispositif comporte des moyens de polarisation 68, tel qu'un générateur de tension continue DC, alternative AC ou RF, dont une borne est reliée à la cible à travers le panier 46 et l'autre borne est reliée à l'enceinte. Le dispositif D4 peut être intégré dans l'enceinte de la figure 1.

Cette polarisation négative de la cible accélère les ions à des énergies dépassant le seuil de pulvérisation, de l'ordre de 50 eV, du matériau de la cible.

Les atomes en phase vapeur sont donc obtenus par pulvérisation assistée par plasma (réactif ou non) au lieu de l'évaporation. Ce mode de réalisation permet de réaliser des dépôts avec des matériaux cible exigeant de très fortes températures d'évaporation et/ou conducteurs électriques ou diélectriques.

Le dispositif pour le dépôt par pulvérisation comporte des moyens de refroidissement de la cible, par exemple par circulation d'un liquide dans un tube en contact avec la cible.

Ce dispositif est plus simple à réaliser que le dispositif pour le dépôt par évaporation du fait de l'absence de moyens de chauffage.

A titre d'exemple uniquement, l'enceinte présente un diamètre de l'ordre de 300 mm permettant de loger une cellule photovoltaïque de 150 mm × 150 mm. Le dispositif pour le dépôt a un diamètre de l'ordre de 200 mm. Le panier a un diamètre de l'ordre de 25, 4 mm.

Sur la figure 8, on peut voir un autre exemple de réalisation de dispositif pour le dépôt D5, dans lequel le coupleur 102 comporte une structure magnétique comprenant des aimants 142.1, 142.2 concentriques d'axe ZZ' entre lesquels le canal de propagation 118 du champ micro-onde est ménagé. Le dispositif 104 peut être configuré pour permettre l'évaporation de la cible C avec ou sans polarisation positive similairement au dispositif 4 ou être configuré pour permettre la pulvérisation de la cible en polarisant négativement celle-ci

Le canal d'injection de micro-onde est plus éloigné radialement de l'axe ZZ' du coupleur. Ce mode de réalisation permet d'étendre davantage la zone de dépôt de puissance micro-onde dans le plasma et, en association avec la configuration du champ magnétique, d'augmenter la surface de production du plasma et donc la surface de dépôt par un dispositif unitaire.

Le dispositif pour le dépôt présentant un encombrement réduit, il est envisageable d'intégrer plusieurs de ces dispositifs D dans une même enceinte agencés spatialement les uns par rapport aux autres pour produire des dépôts sur des substrats de grande surface et/ou de présentant des surfaces de forme complexe. De plus, l'effet cumulatif entre deux dispositifs en position de proche voisin contribue favorablement à l'homogénéisation du plasma. Les dispositifs de dépôt peuvent être disposés les uns par rapport aux autres à toute distance avec pour seule limite l'encombrement physique du dispositif unitaire.

Grâce à l'invention fonctionnant en mode évaporation, le risque d'endommagement de la couche déposée par des espèces de forte énergie est écarté puisqu'elle ne met pas en oeuvre de cathode à un potentiel fortement négatif, qui est source de création des espèces fortement énergétiques dans le plasma. En effet, le dispositif de l'invention est dépourvu de chute cathodique puisque le coupleur et son environnement, tout comme les parois de l'enceinte sont reliés à la masse. Dans l'exemple où une polarisation positive est appliquée à la cible, cette polarisation positive n'introduit pas non plus de chute cathodique.

Comme la pression de fonctionnement de l'installation de dépôt est faible, par exemple entre 0,5 mTorr et 1000 mTorr (0,065 Pa et 133 Pa), il peut néanmoins être envisagé de polariser le substrat lorsqu'un dépôt avec assistance ionique est souhaité. Mais même dans ce cas de figure, il n'y a pas ou peu de risque de détérioration, puisque l'énergie cinétique des ions sur la surface de dépôt est parfaitement contrôlée par les potentiels appliqués et le potentiel du plasma et, pour des potentiels faibles, l'apport énergétique des ions reste limité.-De plus, le substrat peut être refroidi pour évacuer la chaleur du substrat.

Le dispositif de dépôt par évaporation selon l'invention permet d'effectuer des dépôts à vitesse élevée comparativement aux vitesses de dépôt par pulvérisation.

Le dispositif de dépôt par évaporation et le dispositif de dépôt par pulvérisation selon l'invention permettent d'effectuer des dépôts à basse température du substrat, et ce, sans refroidissement intentionnel de celui-ci. Des dépôts sur tout type de substrat et en tout matériau par exemple des matériaux plastiques sont alors possibles.

Le dispositif de dépôt par évaporation et le dispositif de dépôt par pulvérisation selon l'invention permettent d'effectuer des dépôts sur de grandes surfaces par l'utilisation d'autant de dispositifs que nécessaire.

En outre, le dispositif pour le dépôt pour évaporation selon l'invention présente une forte probabilité d'ionisation des particules neutres de vapeur issues de la cible par collisions directes avec les électrons du plasma grâce aux conditions existantes près de la cible : forte densité électronique, énergie effective des électrons de l'ordre de 10 eV à 20 eV, supérieure au seuil d'ionisation des vapeurs tels que In (5,79 eV), Sn (7,34 eV), Mg (7,6 eV), Al (5,98 eV),..., forte densité de vapeurs de faible énergie de l'ordre de 0,03 eV).

Le dispositif pour le dépôt par évaporation et le dispositif de dépôt par pulvérisation présentent avantageusement une symétrie de révolution. Dans le cas où un seul dispositif est utilisé, le plasma devient uniforme au-delà d'une certaine distance à partir de l'extrémité du coupleur, par exemple de l'ordre de 20 cm, ce qui permet de réaliser des dépôts uniformes.

La structure du dispositif de dépôt par évaporation pour le dépôt étant relativement simple il est robuste et offre une grande fiabilité de fonctionnement. La structure du dispositif de dépôt par pulvérisation pour le dépôt est également très simple, voire encore plus simple car le dispositif de dépôt ne requiert pas de moyens de chauffage.

Le dispositif pour le dépôt peut être utilisé pour tout type de dépôt en phase vapeur où les particules en phase vapeur sont obtenues par l'évaporation ou la pulvérisation de la matière à l'état solide.

Le dispositif pour le dépôt s'adapte à différents types de dépôt. Comme cela a été expliqué il permet de réaliser également des dépôts mettant en oeuvre une assistance ionique par polarisation du substrat. Il permet également d'effectuer des dépôts à des températures de substrat contrôlées soit par un chauffage externe, soit par un refroidissement. A titre d'exemple, le substrat peut être chauffé lorsque la cristallisation des films ou la sélection d'une phase de cristallisation requiert davantage d'énergie thermique.

Comme le substrat de dépôt est entièrement découplé du dispositif de production du plasma et des particules en phase vapeur, tout type de condition électrique du substrat (potentiel négatif, à la masse ou flottant) est admise sans que cela modifie le fonctionnement du dispositif pour le dépôt.

Le dispositif pour le dépôt offre également une grande liberté dans le choix de la nature du gaz réactif utilisable, puisqu'il n'y a pas de réactivité avec les matériaux en présence qui donnerait lieu à des dérives de procédé dues aux changement des paramètres plasma lors du procédé. Cela garantit la reproductibilité du procédé.

Le dispositif pour le dépôt et l'installation de dépôt comportant ce dispositif sont particulièrement adaptés aux dépôts par plasma réactif sur des substrats fragiles tels que ceux en matériau plastique, en silicium amorphe hydrogéné... ou en matériaux eux-mêmes sensibles, par exemple en hydrures à base de Mg, ZnO dopé à l'AI - AZO, à la haute température et/ou au bombardement par des particules énergétiques issues du plasma.

Le dispositif pour le dépôt peut par exemple être utilisé pour le dépôt de conducteurs transparents ou TCO (Oxyde Conducteur Transparent en terminologie anglo-saxonne) couramment utilisés dans les applications de grande surface et pour la fabrication de cellules solaires, de fenêtres intelligentes, d'écrans tactiles et de diodes électroluminescentes organiques.

Le dispositif peut être également utilisé pour le dépôt des films céramiques ou métalliques pour la réalisation des oxydes, hydrures, oxynitrures comme SiOxNy, par exemple, utilisés pour la réalisation des barrières transparentes aux vapeurs d'eau.

## Revendications

1. Dispositif pour le dépôt de film mince assisté par plasma comportant un dispositif de production d'un plasma micro-onde par résonance cyclotron électronique (2) et un support (4) d'un matériau cible destiné à former le film mince, ledit dispositif de production d'un plasma micro-onde comportant un corps (10) d'axe longitudinal (ZZ') s'étendant entre une première face d'extrémité longitudinale (14) et une deuxième face d'extrémité longitudinale (16) et muni d'un passage central (12) s'étendant entre la première face d'extrémité longitudinale (14) et la deuxième face d'extrémité longitudinale (16), ledit support (4) étant logé dans ledit passage central (12), ladite première face d'extrémité longitudinale (14) étant destinée à être logée dans une enceinte (E) d'une installation de dépôt, ledit corps (10) comportant un passage annulaire (18) de propagation d'un champ électrique micro-onde relié à une source de champ électrique micro-onde, ledit passage annulaire (18) entourant le passage central (12) et débouchant dans la première face d'extrémité longitudinale (14), au moins une cavité (38) entourant le passage central (12) et située à proximité de la première face d'extrémité longitudinale (14), une structure magnétique (8) logée dans ladite cavité (38), ledit support (4) comportant un panier (46) configuré pour loger la cible (C) et positionné de sorte que la face libre de la cible (C) soit dans un plan de la première face d'extrémité longitudinale (14) ou à proximité dudit plan et de sorte qu'au moins une partie des lignes de champ (B) générée par la structure magnétique (8) croise la cible (C), ledit dispositif pour le dépôt comportant également des moyens d'évaporation ou de pulvérisation du matériau cible.

2. Dispositif pour le dépôt de film mince assisté par plasma selon la revendication 1, dans lesquels les moyens d'évaporation comportent des moyens de polarisation positive du matériau cible logés dans le support.

3. Dispositif pour le dépôt de film mince assisté par plasma selon la revendication 1 ou 2, dans lequel les moyen d'évaporation comportent des moyens de chauffage du matériau cible logé dans le support (4).

4. Dispositif pour le dépôt de film mince assisté par plasma selon la revendication 3, dans lequel les moyens de chauffage du matériau cible sont des moyens de chauffage à effet Joule ou par induction.

5. Dispositif pour le dépôt de film mince assisté par plasma selon la revendication 1, dans lequel les moyens de pulvérisation comportent des moyens de polarisation négative du matériau cible logé dans le support (4).

6. Dispositif pour le dépôt de film mince assisté par plasma selon la revendication 5, comportant des moyens de refroidissement du matériau cible logés dans le support (4).

7. Dispositif pour le dépôt de film mince assisté par plasma selon l'une des revendications 1 à 6, comportant des moyens de refroidissement du corps du dispositif de production d'un plasma micro-onde.

8. Dispositif pour le dépôt de film mince assisté par plasma selon l'une des revendications 1 à 7, dans lequel la structure magnétique (8) comporte au moins un aimant permanent (42).

9. Dispositif pour le dépôt de film mince assisté par plasma selon l'une des revendications 1 à 8, dans lequel la structure magnétique (8) comporte au moins un aimant permanent à aimantation radiale (42.2).

10. Dispositif pour le dépôt de film mince assisté par plasma selon l'une des revendications 1 à 8, dans lequel la structure magnétique (8) comporte au moins un aimant permanent à aimantation axiale dipolaire (42.3).

11. Dispositif pour le dépôt de film mince assisté par plasma selon l'une des revendications 1 à 8, dans lequel la structure magnétique (8) comporte au moins deux aimants permanents à aimantation axiale (42.1) de polarité opposée.

12. Dispositif pour le dépôt de film mince assisté par plasma selon l'une des revendications 1 à 11, comportant deux structures magnétiques concentriques et dans lequel le passage annulaire de propagation (18) débouche dans la première face d'extrémité longitudinale entre les deux structures magnétiques.

13. Dispositif pour le dépôt de film mince assisté par plasma selon l'une des revendications 1 à 12, dans lequel le corps (10) du dispositif de production d'un plasma micro-onde comporte un conducteur intérieur (24) et un conducteur extérieur (26) emboîtés l'un dans l'autre et définissant entre eux une partie du passage annulaire de propagation de l'onde.

14. Installation de dépôt de film mince assisté par plasma sur un substrat, comportant une enceinte (E) étanche, un porte-substrat (PS) et au moins un dispositif (D) pour le dépôt de film mince assisté par plasma selon l'une des revendications précédentes monté de manière étanche à travers une paroi (F) de l'enceinte (E), de sorte que la première face d'extrémité longitudinale (14) du corps (10) soit à l'intérieur de l'enceinte (E).

15. Installation de dépôt de film mince assisté par plasma selon la revendication précédente, dans laquelle la paroi (F) de l'enceinte est contenue dans un plan (P2) et le dispositif pour le dépôt de film mince assisté par plasma est monté dans la paroi de sorte que les intersections des lignes de champ magnétique et de ladite paroi sont minimisées.

16. Installation de dépôt de film mince assisté par plasma selon la revendication 14 ou 15, dans laquelle la pression de gaz plasmagène dans l'enceinte est comprise entre 0,065 Pa et 133 Pa.

17. Installation de dépôt de film mince assisté par plasma selon l'une des revendications 14 à 16, comportant des moyens de polarisation et/ou de chauffage du substrat.

## Patentansprüche

1. Vorrichtung zur plasmaunterstützten Dünnfilmabscheidung, eine Vorrichtung zur Erzeugung eines Mikrowellen-Plasmas durch elektronische Zyklotronresonanz (2) enthaltend, und einen Träger (4) eines Objektmaterials, das vorgesehen ist, um den Dünnfilm zu bilden, wobei die Vorrichtung zur Erzeugung eines Mikrowellen-Plasmas einen Körper (10) mit Längsachse (ZZ') enthält, der sich zwischen einer ersten Seite mit Längsende (14) und einer zweiten Seite mit Längsende (16) erstreckt und mit einem zentralen Durchgang (12) versehen ist, der sich zwischen der ersten Seite mit Längsende (14) und der zweiten Seite mit Längsende (16) erstreckt, wobei der Träger (4) im zentralen Durchgang (12) untergebracht ist, und die erste Seite mit Längsende (14) dazu bestimmt ist, in einem Gehäuse (E) einer Abscheidungsanlage untergebracht zu werden, wobei der Körper (10) einen ringförmigen Durchgang (18) zur Ausbreitung eines elektrischen Mikrowellenfelds enthält, der mit einer Quelle des elektrischen Mikrowellenfelds verbunden ist, wobei der ringförmige Durchgang (18) den zentralen Durchgang (12) umgibt und in die erste Seite mit Längsende (14) mündet, wobei mindestens ein Hohlraum (38) den zentralen Durchgang (12) umgibt und sich in der Nähe der ersten Seite mit Längsende (14) befindet, wobei eine magnetische Struktur (8) im Hohlraum (38) untergebracht ist, wobei der Träger (4) einen Korb (46) enthält, der konfiguriert ist, um das Objekt (C) unterzubringen, und so positioniert ist, dass die freie Seite des Objekts (C) in einer Ebene der ersten Seite mit Längsende (14) oder in der Nähe der Ebene liegt, und so, dass mindestens ein Teil der Feldlinien (B), die durch die magnetische Struktur (8) generiert werden, das Objekt (C) kreuzt, wobei die Abscheidungsvorrichtung auch Mittel zum Verdampfen oder Versprühen des Objektmaterials enthält.

2. Vorrichtung zur plasmaunterstützten Dünnfilmabscheidung nach Anspruch 1, wobei die Verdampfungsmittel Mittel zur positiven Polarisation des Objektmaterials, die im Träger untergebracht sind, enthalten.

3. Vorrichtung zur plasmaunterstützten Dünnfilmabscheidung nach Anspruch 1 oder 2, wobei die Verdampfungsmittel Mittel zum Erhitzen des Objektmaterials, das im Träger (4) untergebracht ist, enthalten.

4. Vorrichtung zur plasmaunterstützten Dünnfilmabscheidung nach Anspruch 3, wobei die Mittel zur Erhitzung des Objektmaterials Erhitzungsmittel mit Joule-Effekt oder durch Induktion sind.

5. Vorrichtung zur plasmaunterstützten Dünnfilmabscheidung nach Anspruch 1, wobei die Sprühmittel Mittel zur negativen Polarisation des Objektmaterials, das im Träger (4) untergebracht ist, enthalten.

6. Vorrichtung zur plasmaunterstützten Dünnfilmabscheidung nach Anspruch 5, Mittel zum Abkühlen des Objektmaterials, das im Träger (4) untergebracht sind, enthaltend.

7. Vorrichtung zur plasmaunterstützten Dünnfilmabscheidung nach einem der Ansprüche 1 bis 6, Mittel zum Abkühlen des Körpers der Vorrichtung zur Erzeugung eines Mikrowellen-Plasmas enthaltend.

8. Vorrichtung zur plasmaunterstützten Dünnfilmabscheidung nach einem der Ansprüche 1 bis 7, wobei die magnetische Struktur (8) mindestens einen Permanentmagneten (42) enthält.

9. Vorrichtung zur plasmaunterstützten Dünnfilmabscheidung nach einem der Ansprüche 1 bis 8, wobei die magnetische Struktur (8) mindestens einen radial magnetisierten Permanentmagneten (42.2) enthält.

10. Vorrichtung zur plasmaunterstützten Dünnfilmabscheidung nach einem der Ansprüche 1 bis 8, wobei die magnetische Struktur (8) mindestens einen dipolaren axial magnetisierten Permanentmagneten (42.3) enthält.

11. Vorrichtung zur plasmaunterstützten Dünnfilmabscheidung nach einem der Ansprüche 1 bis 8, wobei die magnetische Struktur (8) mindestens zwei axial magnetisierte Permanentmagnete (42.1) mit entgegengesetzter Polarität enthält.

12. Vorrichtung zur plasmaunterstützten Dünnfilmabscheidung nach einem der Ansprüche 1 bis 11, zwei konzentrische magnetische Strukturen enthaltend, und wobei der ringförmige Ausbreitungsdurchgang (18) in die erste Seite mit Längsende zwischen den zwei magnetischen Strukturen mündet.

13. Vorrichtung zur plasmaunterstützten Dünnfilmabscheidung nach einem der Ansprüche 1 bis 12, wobei der Körper (10) der Vorrichtung zur Erzeugung eines Mikrowellen-Plasmas einen inneren Leiter (24) und einen äußeren Leiter (26) enthält, die ineinander verschachtelt sind und zwischen ihnen einen Teil des ringförmigen Durchgangs der Wellenausbreitung definieren.

14. Anlage zur plasmaunterstützten Dünnfilmabscheidung auf einem Substrat, ein dichtes Gehäuse (E) enthaltend, einen Substrathalter (PS) und mindestens eine Vorrichtung (D) zur plasmaunterstützten Dünnfilmabscheidung nach einem der vorhergehenden Ansprüche, die auf dichte Weise durch eine Wand (F) des Gehäuses (E) hindurch montiert ist, so dass sich die erste Seite mit Längsende (14) des Körpers (10) innerhalb des Gehäuses (E) befindet.

15. Anlage zur plasmaunterstützten Dünnfilmabscheidung nach dem vorhergehenden Anspruch, wobei die Wand (F) des Gehäuses in einer Ebene (P2) beinhaltet ist und die Vorrichtung zur plasmaunterstützten Dünnfilmabscheidung in der Wand so montiert ist, dass die Schnittpunkte der Magnetfeldlinien und der Wand minimiert werden.

16. Anlage zur plasmaunterstützten Dünnfilmabscheidung nach Anspruch 14 oder 15, wobei der Druck des plasmagenen Gases im Gehäuse zwischen 0,065 Pa und 133 Pa liegt.

17. Anlage zur plasmaunterstützten Dünnfilmabscheidung nach einem der Ansprüche 14 bis 16, Mittel zur Polarisation und/oder Erhitzung des Substrats enthaltend.

## Claims

1. A plasma-assisted thin film deposition device including a device for producing a microwave plasma by electron cyclotron resonance (2) and a support (4) of a target material intended to form the thin film, said device for producing a microwave plasma including a body (10) with a longitudinal axis (ZZ') extending between a first longitudinal end face (14) and a second longitudinal end face (16) and provided with a central passage (12) extending between the first longitudinal end face (14) and the second longitudinal end face (16), said support (4) being housed in said central passage (12), said first longitudinal end face (14) being intended to be housed in an enclosure (E) of a deposition installation, said body (10) including an annular passage (18) for propagating a microwave electric field connected to a microwave electric field source, said annular passage (18) surrounding the central passage (12) and opening into the first longitudinal end face (14), at least one cavity (38) surrounding the central passage (12) and located near the first longitudinal end face (14), a magnetic structure (8) housed in said cavity (38), said support (4) including a basket (46) configured to house the target (C) and positioned so that the free face of the target (C) is in a plane of the first longitudinal end face (14) or near said plane and so that at least part of the field lines (B) generated by the magnetic structure (8) crosses the target (C), said deposition device also including means for evaporating or spraying the target material.

2. The plasma-assisted thin film deposition device according to claim 1, wherein the evaporation means include positive polarisation means of the target material housed in the support.

3. The plasma-assisted thin film deposition device according to claim 1 or 2, wherein the evaporation means include means for heating the target material housed in the support (4).

4. The plasma-assisted thin film deposition device according to claim 3, wherein the means for heating the target material are Joule effect or induction heating means.

5. The plasma-assisted thin film deposition device according to claim 1, wherein the spraying means include negative polarisation means of the target material housed in the support (4).

6. The plasma-assisted thin film deposition device according to claim 5, including means for cooling the target material housed in the support (4).

7. The plasma-assisted thin film deposition device according to one of claims 1 to 6, including means for cooling the body of the device for producing a microwave plasma.

8. The plasma-assisted thin film deposition device according to one of claims 1 to 7, wherein the magnetic structure (8) includes at least one permanent magnet (42).

9. The plasma-assisted thin film deposition device according to one of claims 1 to 8, wherein the magnetic structure (8) includes at least one radially magnetised permanent magnet (42.2).

10. The plasma-assisted thin film deposition device according to one of claims 1 to 8, wherein the magnetic structure (8) includes at least one permanent magnet with dipole axial magnetisation (42.3).

11. The plasma-assisted thin film deposition device according to one of claims 1 to 8, wherein the magnetic structure (8) includes at least two axially magnetised permanent magnets (42.1) of opposite polarity.

12. The plasma-assisted thin film deposition device according to one of claims 1 to 11, including two concentric magnetic structures and wherein the annular propagation passage (18) opens into the first longitudinal end face between the two magnetic structures.

13. The plasma-assisted thin film deposition device according to one of claims 1 to 12, wherein the body (10) of the device for producing a microwave plasma includes an inner conductor (24) and an outer conductor (26) interlocked one inside the other and defining therebetween a part of the annular wave propagation passage.

14. An installation for plasma-assisted thin film deposition on a substrate, including a sealed enclosure (E), a substrate holder (PS) and at least one plasma-assisted thin film deposition device (D) according to one of the preceding claims mounted in a sealed manner through a wall (F) of the enclosure (E), such that the first longitudinal end face (14) of the body (10) is inside the enclosure (E).

15. The plasma-assisted thin film deposition installation according to the preceding claim, wherein the wall (F) of the enclosure is contained in a plane (P2) and the plasma-assisted thin film deposition device is mounted in the wall so that the intersections of the magnetic field lines and said wall are minimised.

16. The plasma-assisted thin film deposition installation according to claim 14 or 15, wherein the plasma gas pressure in the enclosure is comprised between 0.065 Pa and 133 Pa.

17. The plasma-assisted thin film deposition installation according to one of claims 14 to 16, including means for polarising and/or heating the substrate.
